# EUROPÄISCHE PATENTSCHRIFT

(11) **EP 3 152 606 B1**
(45) Veröffentlichungstag und Bekanntmachung des Hinweises auf die Patenterteilung: **10.07.2019**
(21) Anmeldenummer: 15724178.7
(22) Anmeldetag: 26.05.2015
(51) Int. Cl.: G02B 6/02, G02B 1/10

(54) **ENDFLÄCHENBESCHICHTUNG EINES WELLENLEITERS**
END FACE COATING OF A WAVEGUIDE
REVÊTEMENT DES FACES D'EXTRÉMITÉ D'UN GUIDE D'ONDE

(30) Priorität: 05.06.2014 DE 102014008369
(43) Veröffentlichungstag der Anmeldung: 12.04.2017
(73) Patentinhaber: Rosenberger-OSI GmbH & Co. OHG, 86167 Augsburg (DE)
(72) Erfinder: WEIGAND, Benjamin, 67655 Kaiserslautern (DE); THEOBALD, Christian, 86153 Augsburg (DE); L'HUILLIER, Johannes Albert, 67317 Altleiningen (DE)
(74) Vertreter: Zeitler Volpert Kandlbinder Patent- und Rechtsanwälte Partnerschaft mbB
(86) Internationale Anmeldenummer: PCT/EP2015/001076
(87) Internationale Veröffentlichungsnummer: WO 2015/185194

(56) Entgegenhaltungen:
- EP-A2- 2 267 501
- WO-A1-2011/053859
- DE-A1-102008 018 866
- JP-A- 2000 290 396
- JP-A- 2003 294 901

## Beschreibung

Die Erfindung betrifft einen optischen Wellenleiter, insbesondere eine optische Faser, wobei der Wellenleiter eine mit einer Beschichtung versehene Frontfläche aufweist, wobei die Beschichtung eine oder mehrere organische Fluorverbindungen aufweist, gemäß dem Oberbegriff von Anspruch 1 oder 2. Die Erfindung betrifft weiterhin ein Verfahren zum Herstellen eines derartigen Wellenleiters, gemäß dem Oberbegriff von Anspruch 9 oder 10.

Ein Wellenleiter wie etwa eine optische Faser kann zur Lichtleitung im UV-Bereich, im sichtbaren Bereich und/oder im IR-Bereich vorgesehen sein. Wellenleiter weisen regelmäßig eine Frontfläche auf, durch die das Licht aus dem Wellenleiter austritt und/oder in den Wellenleiter eintritt. Die Frontfläche kann zumindest zeitweise in Kontakt mit der Umgebung stehen und ist deshalb in besonderem Maße anfällig für Verschmutzungen. Wenn das vordere Ende des Wellenleiters in einen LWL-Steckverbinder eingebaut ist, kann die Frontfläche ferner ggf. mechanischen Belastungen durch Steckvorgänge ausgesetzt sein, wobei die Frontfläche oftmals während ihres Einsatzes mehrere hundert bis tausende Steckzyklen überstehen muss.

Verschmutzungen oder Beschädigungen der Frontfläche können dazu führen, dass die Lichtdurchlässigkeit abnimmt und sich somit die Übertragungseigenschaften des Wellenleiters insgesamt verschlechtern. Im Extremfall wird der Wellenleiter bei einer Verschmutzung seiner Frontfläche unbrauchbar.

Es ist bereits beispielsweise aus der DE 10 2008 018 866 A1 bekannt, Frontflächen von Wellenleitern mit Beschichtungen wie etwa Antireflexionsbeschichtungen (AR-Coatings) zu versehen, um den Lichtdurchtritt durch die Frontfläche zu erhöhen bzw. um Reflexionen zu verringern. Es hat sich allerdings herausgestellt, dass die mechanischen Eigenschaften von Wellenleiter-Frontflächen und deren Resistenz gegen Verschmutzungen trotz solcher Beschichtungen regelmäßig unzureichend sind.

Die Druckschrift WO 2011/053859 A1 zeigt einen Wellenleiter für eine wiederholt lösbare und schließbare Wellenleiter-Verbindungsstelle, wobei der Wellenleiter eine mit einer Beschichtung versehenen Faser aufweist, wobei die Beschichtung mit einer optisch glatten und schlecht haftenden Oberfläche ausgebildet ist. Die Beschichtung ist beispielsweise ein Acrylmonomer und kann zur Anpassung des Brechungsindex fluorinierte Komponenten enthalten, wie beispielsweise F8DA (fluoriniertes Hexanid Diacrylat) oder TFPM (Tetrafluorpropyl Methacrylat).

In Anbetracht der beschriebenen Probleme ist es die Aufgabe der vorliegenden Erfindung, einen Wellenleiter mit einer beschichteten Frontfläche bereitzustellen, die auch über einen langen Einsatzzeitraum hinweg zuverlässig hohe Transmissionseigenschaften gewährleistet, so dass der Wellenleiter dauerhaft wartungsfrei einsetzbar ist.

Diese Aufgabe wird erfindungsgemäß durch einen Wellenleiter gemäß Anspruch 1 oder 2 und durch ein Verfahren zum Herstellen eines Wellenleiters gemäß Anspruch 9 oder 10 gelöst. Vorteilhafte Weiterbildungen der Erfindung sind in den abhängigen Ansprüchen beschrieben.

Bei einem Wellenleiter der o.g. Art ist es erfindungsgemäß vorgesehen, dass Beschichtung plasmabehandelt ist, wodurch auf der Frontfläche in Abhängigkeit von den eingestellten Verfahrensparametern ein Ätzgras gebildet ist wobei die Beschichtung plasmapolymerisiertes Octafluorocyclobutan (PP-OFCB) aufweist.

Bei einem Wellenleiter der o.g. Art ist es ferner erfindungsgemäß vorgesehen, dass die Frontfläche plasmabehandelt ist, wodurch auf der Frontfläche in Abhängigkeit von den eingestellten Verfahrensparametern ein Ätzgras gebildet ist, wobei die Beschichtung plasmapolymerisiertes Octafluorocvclobutan (PP-OFCB) aufweist, wobei die Dicke der PP-OFCB-Beschichtung derart gewählt ist, dass die zuvor in die Faserfrontfläche eingebrachte Strukturierung auch nach dem Beschichten an der äußeren Beschichtungsfläche noch vorhanden ist.

Bei einem Verfahren der o.g. Art ist es erfindungsgemäß vorgesehen, dass eine Frontfläche des Wellenleiters durch Plasmapolymerisation unter Verwendung von OFCB als Präkursor mit einer organische Fluorverbindungen aufweisenden Beschichtung beschichtet wird, und die Frontfläche vor der Beschichtung plasmabehandelt wird, wodurch auf der Frontfläche in Abhängigkeit von den eingestellten Verfahrensparametern ein Ätzgras entsteht, wobei die Dicke der PP-OFCB-Beschichtung so gewählt wird, dass die zuvor in die Faserfrontfläche eingebrachte Strukturierung auch nach dem Beschichten an der äußeren Beschichtungsfläche noch vorhanden ist..

Bei einem Verfahren der o.g. Art ist es ferner erfindungsgemäß vorgesehen, dass eine Frontfläche des Wellenleiters durch Plasmapolymerisation unter Verwendung von OFCB als Präkursor mit einer organische Fluorverbindungen aufweisenden Beschichtung beschichtet wird, und die Frontfläche nach der Beschichtung plasmabehandelt wird, wodurch auf der Frontfläche in Abhängigkeit von den eingestellten Verfahrensparametern ein Ätzgras entsteht.

Besonders bevorzugt besteht zumindest eine Schicht der Beschichtung oder die gesamte Beschichtung (abgesehen von Verunreinigungen) im Wesentlichen ausschließlich aus PP-OFCB. Mit anderen Worten weist die Frontfläche des Wellenleiters vorzugsweise einen Deckfilm aus PP-OFCB auf. Unter plasmapolymerisiertem OFCB (PP-OFCB) werden durch Plasmapolymerisation unter Verwendung von OFCB als Präkursor auf der Frontfläche des Wellenleiters aufgewachsene bzw. abgeschiedene Plasmapolymere (insbes. organische Fluorverbindungen wie etwa Fluorcarbone etc.) verstanden.

Die Erfindung geht auf die Erkenntnis zurück, dass herkömmliche Beschichtungen von Wellenleiter-Frontflächen nicht ausreichend schmutzabweisend sind, so dass sich im Laufe des Einsatzes des Wellenleiters bspw. Staub, Flüssigkeiten, Öle etc. auf der Frontfläche absetzen können und die Transmissionseigenschaften beeinträchtigen können. Organische Fluorverbindungen, insbesondere Filme aus PP-OFCB haben hydrophobe und oleophobe Eigenschaften, so dass eine solche Ablagerung von unerwünschten Stoffen auf der Frontfläche zuverlässig verhindert werden kann, so dass die Einsatzdauer des Wellenleiters durch Beschichtung mit PP-OFCB erhöht werden kann bzw. der zeitliche Abstand zwischen einzelnen Reinigungsschritten vergrößert werden kann.

Versuche haben ergeben, dass PP-OFCB mit seinen Teflon (Polytetrafluorethylen, C₂F₄) ähnlichen Eigenschaften als Durchflusssperre einsetzbar ist, die der Überströmung von destilliertem Wasser, Aceton, Isopropanol, stark benetzendem Polysorbat wie auch weiteren Stoffen sehr lange standhalten kann. Damit kann eine mit einer PP-OFCB-Beschichtung versehene Frontfläche eines Wellenleiters bspw. mit Aceton oder anderen Reinigungsmitteln mehrfach gereinigt werden, ohne das mechanische oder sonstige Beschädigungen der Beschichtung zu befürchten sind.

Hinzu kommt, dass organische Fluorverbindungen aufweisendes PP-OFCB auch im Hinblick auf die erforderlichen optischen Eigenschaften als Beschichtungsmaterial geeignet ist. So zeichnet sich eine PP-OFCB-Schicht durch eine geringe Absorption elektromagnetischer Strahlung in den für die Datenkommunikation wichtigen nahinfraroten Bändern, aber auch insbesondere im Bereich von 400 nm bis 700 nm aus.

Ferner ist PP-OFCB in kontrollierter Weise in dünnen Schichten vorgegebener Schichtdicke (wenige 10 nm bis hin zu Mikrometern) auf einer Wellenleiter-Frontfläche, die bspw. aus Quarzglas bestehen kann, aufbringbar. Als geeignetes Verfahren zum Aufbringen der Beschichtung hat sich die Plasmapolymerisation erwiesen, mithilfe derer eine PP-OFCB-Schicht in einer sehr exakt kontrollierbaren Abscheidungsdicke auf der Frontfläche abgeschieden werden kann. Die Plasmapolymerisation von OFCB ist bereits aus dem sogenannten Bosch-Prozess bekannt und findet Anwendung in DRIE-Prozessen (Deep Reactive Ion Etching), die zur Herstellung von tiefen Mikrostrukturen verwendet werden. Details des Verfahrens der Plasmapolymerisation von OFCB sind bspw. in der Veröffentlichung "Hydrophobic valves of plasma deposited octafluorocyclobutanate in DRIE channels", H. Andersson et al., Sensors and Actuators (2001), pp. 136ff. erläutert, und werden durch Verweis in die vorliegende Offenbarung aufgenommen.

Eine PP-OFCB-Schicht hat einen Brechungsindex von etwa n=1,4, der nicht notwendigerweise dem Brechungsindex des Wellenleitermaterials entspricht. Im Hinblick auf eine gute Brechungsindexanpassung hat es sich als vorteilhaft erwiesen, der Beschichtung einen weiteren Stoff mit einem abweichenden Brechungsindex hinzuzufügen, der vorzugsweise ebenfalls durch Plasmapolymerisation aufgebracht bzw. abgeschieden werden kann.

Vorzugsweise weist die Beschichtung zusätzlich Benzol (C₆H₆) und/oder Polymerisationsprodukte von Benzol, insbesondere plasmapolymerisiertes Benzol (PP-Benzol) auf. Eine Schicht aus PP-Benzol hat zufriedenstellende optische Eigenschaften, insbesondere gute Transmissionseigenschaften in den betreffenden optischen Bereichen, und kann ebenfalls durch Plasmapolymerisation auf der Frontfläche aufgebracht werden. Eine PP-Benzolschicht hat einen Brechungsindex von etwa n=1,62.

Der Brechungsindex der Beschichtung kann an den Brechungsindex des Wellenleitermaterials angepasst werden, indem die Beschichtung eine Schicht aus PP-OFCB und PP-Benzol in einem vorgegebenen Mischverhältnis aufweist. Vorzugsweise werden PP-OFCB und PP-Benzol gleichzeitig in einem Plasmapolymerisationsschritt auf der Frontfläche des Wellenleiters aufgebracht, wobei je nach dem für den Prozess eingestellten Mischverhältnis Brechungsindizes der Beschichtung zwischen n=1,4 und n=1,62 einstellbar sind.

Wenn der Wellenleiter Quarzglas aufweist, hat sich ein Brechungsindex der Beschichtung von etwa n=1,45 als besonders zweckmäßig erwiesen.

Alternativ oder zusätzlich kann die Beschichtung mehrere Schichten in einer vorgegebenen Abfolge aufweisen. Bspw. ist es möglich, durch ein Alternieren von Schichten aus PP-OFCB und PP-Benzol durch sequentielle Polymerisation von C₄F₈ und C₆H₆ Antireflexionsschichten, Filterschichten und/oder Schichten mit besonderer Farbgebung aufgrund einer Erhöhung von Reflexion und/oder Transmission in bestimmen Wellenlängenbereichen bereitzustellen.

Erfindungsgemäß sind die Frontfläche des Wellenleiters und/oder die äußere Fläche der Beschichtung strukturiert und/oder aufgeraut. Durch eine solche Strukturierung (bzw. Aufrauung im nm-Bereich) können die hydrophoben und/oder oleophoben Eigenschaften der Oberfläche aufgrund der mit der Aufrauung verbundenen Oberflächenvergrößerung weiter verbessert werden.

Diese Verbesserung der oleophoben und hydrophoben Wirkung durch die Strukturierung ist dann besonders gut, wenn die regelmäßig der Umgebung ausgesetzte äußere Beschichtungsoberfläche strukturiert ist.

Durch eine Strukturierung der Frontfläche des Wellenleiters vor der Beschichtung können zum einen die Haftungseigenschaften der Beschichtung auf der Frontfläche verbessert werden. Zum anderen kann sich die Strukturierung zumindest im Falle einer dünnen Beschichtung mit einer Dicke im Nanometerbereich bis hin zu der äußeren Beschichtungsoberfläche fortsetzen, so dass die beschriebene verbesserte oleophobe und hydrophobe Wirkung ggf. ebenfalls erzielbar ist.

Als besonders vorteilhaft im Hinblick auf einen Verschmutzungs-Abweisungseffekt hat es sich erwiesen, dass die Frontfläche des Wellenleiters und/oder die äußere Fläche der Beschichtung zur Bildung einer Strukturierung mit einer Strukturierungstiefe zwischen 1 nm und 100 nm, insbesondere zwischen 1 nm und 10 nm plasmabehandelt, insbesondere sauerstoffplasmabehandelt ist.

Der Plasmaätzschritt wie etwa eine Behandlung mit Sauerstoffplasma kann vor und/oder nach dem Beschichtungsschritt erfolgen, wobei ein Plasmaätzschritt vor dem Beschichtungsschritt zusätzlich die Abriebsfestigkeit der Beschichtung gegenüber der Frontfläche und damit die mechanischen Eigenschaften der beschichteten Frontfläche verbessern kann.

Vorzugsweise ist die Frontfläche Facette einer optischen Faser und/oder Teil eines LWL-Steckverbinders.

Gemäß einem weiteren Gesichtspunkt betrifft die Erfindung ein Verfahren zum Herstellen eines erfindungsgemäßen Wellenleiters wie etwa einer optischen Faser, bei dem die Frontfläche des Wellenleiters durch Plasmapolymerisation unter Verwendung von OFCB als Präkursor mit einer eine organische Fluorverbindung aufweisenden Beschichtung beschichtet wird.

Vorzugsweise werden bei der Plasmapolymerisation gleichzeitig oder alternierend OFCB und Benzol als Präkursoren verwendet, so dass die Frontfläche gleichzeitig oder alternierend mit PP-OFCB und PP-Benzol beschichtet wird.

Durch eine alternierende Beschichtung unter Verwendung von OFCB und Benzol als Präkursoren wird eine alternierende Schichtfolge auf der Frontfläche gebildet, die als AR-Coating und/oder zum Bereitstellen einer besonderen Farbgebung vorgesehen sein kann.

Durch das Aufbringen einer Mischschicht mit zwei Typen von Plasmapolymeren (PP-OFCB und PP-Benzol) mit abweichenden Brechungsindizes kann der Brechungsindex der Beschichtung an denjenigen des Wellenleitermaterials angepasst werden.

Die Frontfläche des Wellenleiters wird vor und/oder nach dem Beschichtungsschritt bevorzugt mittels einer Plasma- und/oder Ätzbehandlung wie etwa einer Sauerstoffplasmabehandlung aufgeraut. Es wird auf die obigen Ausführungen und Erläuterungen verwiesen.

In der nun folgenden Beschreibung wird die Erfindung unter Bezugnahme auf die beigefügten Zeichnungen erläutert. Dabei zeigen
Fig. 1: in schematischen Darstellungen ein Verfahren zum Herstellen eines erfindungsgemäßen Wellenleiters in drei Verfahrensschritten,
Fig. 2: in schematischen Darstellungen ein abgewandeltes Verfahren zum Herstellen eines erfindungsgemäßen Wellenleiters in drei Verfahrensschritten.

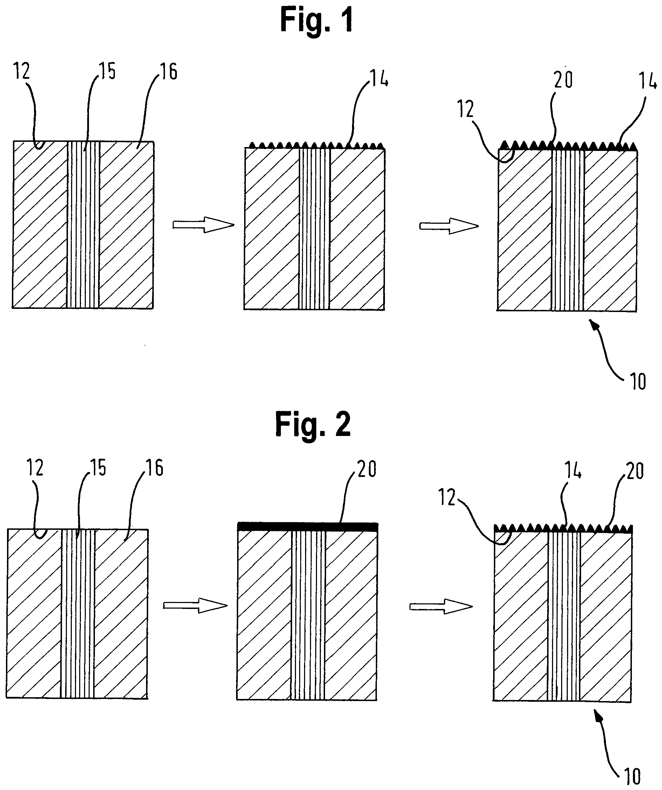

In den Figuren 1 und 2 ist in der linken Darstellung jeweils ein Wellenleiter 10 in Form einer optischen Faser wie etwa einer Glasfaser vor der Beschichtung des Wellenleiters dargestellt. Der Wellenleiter 10 weist einen Signalkern 15 und einen den Signalkern 15 koaxial umlaufenden Mantel 16 (Cladding) auf. Über eine Frontfläche 12 des Wellenleiters 10 kann bei Verwendung des Wellenleiters Licht in den Signalkern 15 der Faser eintreten und/oder aus dem Signalkern 15 austreten. Mit anderen Worten ist die Frontfläche bei dem dargestellten Beispiel eine quer zur Faserlängsrichtung verlaufende Faserfacette.

Diese Frontfläche 12 wird gemäß dem in Fig. 1 dargestellten Herstellungsverfahren zunächst aufgeraut bzw. strukturiert (siehe Darstellung in der Mitte). Zu diesem Zweck kann die Frontfläche 12 sauerstoffplasmabehandelt werden, wodurch auf der Frontfläche 12 in Abhängigkeit von den eingestellten Verfahrensparameters ein Ätzgras mit einer Aufrauhung einer Tiefe im nm-Bereich bis hin zu 100 nm entsteht.

Die Strukturierung 14 wird anschließend durch Plasmapolymerisation unter Verwendung von OFCB als Präkursor mit organischen Fluorverbindungen beschichtet (siehe Darstellung rechts). Die Dicke der PP-OFCB-Beschichtung 20 wird so gewählt, dass die zuvor in die Faserfrontfläche 12 eingebrachte Strukturierung 14 auch nach dem Beschichten an der äußeren Beschichtungsfläche (ggf. mit verringerter Strukturierungstiefe und Strukturierungskontur) noch vorhanden ist. Durch die an der äußeren Fläche der Beschichtung 20 vorhandene Aufrauhung können die oleophoben und hydrophoben Eigenschaften der beschichteten Frontfläche weiter verbessert werden.

Die Beschichtung 20 kann neben PP-OFCB auch PP-Benzol aufweisen, wobei das PP-Benzol alternierend oder gleichzeitig mit dem PP-OFCB durch Plasmapolymerisation aufgebracht werden kann.

Gemäß dem in Fig. 2 dargestellten, alternativen Herstellungsverfahren wird die im Wesentlichen ebene Frontfläche 12 des Wellenleiters 10 zunächst durch Plasmapolymerisation unter Verwendung von OFCB als Präkursor beschichtet (siehe Darstellung in der Mitte). Die Beschichtung 20 kann neben PP-OFCB auch PP-Benzol aufweisen, wobei das Benzol alternierend oder gleichzeitig mit dem OFCB durch Plasmapolymerisation aufgebracht werden kann.

Die ebene äußere Fläche der Beschichtung 20 wird anschließend aufgeraut. Die Aufrauhung kann ebenso wie bei dem in Fig. 1 dargestellten Herstellungsverfahren durch eine Plasmabehandlung wie etwa eine Sauerstoffplasmabehandlung erfolgen.

Bei den dargestellten Beispielen ist jeweils die gesamte Frontfläche des Wellenleiters beschichtet und aufgeraut. Es ist ebenso möglich, nur einen Teilbereich wie etwa einen zentralen Bereich der Frontfläche zu beschichten und ggf. aufzurauen. Je nach Material des Wellenleiters können Benzol und OFCB bei der Polymerisation in einem entsprechenden Mischverhältnis verwendet werden, um eine Brechungsindexanpassung zu erreichen.

## Patentansprüche

1. Optischer Wellenleiter (10), insbesondere optische Faser, mit einer eine Beschichtung (20) aufweisenden Frontfläche (12), wobei die Beschichtung (20) eine oder mehrere organische Fluorverbindungen aufweist, **dadurch gekennzeichnet, dass** die Beschichtung plasmabehandelt ist, wodurch auf der Frontfläche (12) in Abhängigkeit von den eingestellten Verfahrensparametem ein Ätzgras gebildet ist, wobei die Beschichtung (20) plasmapolymerisiertes Octafluorocyclobutan (PP-OFCB) aufweist.

2. Optischer Wellenleiter (10), insbesondere optische Faser, mit einer eine Beschichtung (20) aufweisenden Frontfläche (12), wobei die Beschichtung (20) eine oder mehrere organische Fluorverbindungen aufweist, **dadurch gekennzeichnet, dass** die Frontfläche (12) plasmabehandelt ist, wodurch auf der Frontfläche (12) in Abhängigkeit von den eingestellten Verfahrensparametern ein Ätzgras gebildet ist, wobei die Beschichtung (20) plasmapolymerisiertes Octafluorocyclobutan (PP-OFCB) aufweist, wobei die Dicke der PP-OFCB-Beschichtung (20) derart gewählt ist, dass die zuvor in die Faserfrontfläche (12) eingebrachte Strukturierung (14) auch nach dem Beschichten an der äußeren Beschichtungsfläche noch vorhanden ist.

3. Wellenleiter nach Anspruch 1 oder 2, **dadurch gekennzeichnet, dass** die Beschichtung ferner Benzol und/oder Polymerisationsprodukte von Benzol, insbesondere plasmapolymerisiertes Benzol (PP-Benzol), aufweist.

4. Wellenleiter nach Anspruch 3, **dadurch gekennzeichnet, dass** die Beschichtung eine Schicht aus PP-OFCB und PP-Benzol in einem vorgegebenen Mischverhältnis aufweist.

5. Wellenleiter nach Anspruch 34, **dadurch gekennzeichnet, dass** das Mischverhältnis derart eingestellt ist, dass der Brechungsindex der Schicht an den Brechungsindex eines Materials des Wellenleiters angepasst ist, wobei der Brechungsindex der Schicht vorzugsweise etwa n=1,45 beträgt.

6. Wellenleiter nach einem der vorhergehenden Ansprüche, **dadurch gekennzeichnet, dass** die Beschichtung alternierend Schichten aus PP-OFCB und PP-Benzol aufweist.

7. Wellenleiter nach einem der vorhergehenden Ansprüche, **dadurch gekennzeichnet, dass** die Frontfläche (12) des Wellenleiters (10) und/oder die äußere Fläche der Beschichtung (20) zur Bildung des Ätzgrases sauerstoffplasmabehandelt ist.

8. Wellenleiter nach einem der vorhergehenden Ansprüche, **dadurch gekennzeichnet, dass** die Frontfläche (12) eine Faserfacette ist.

9. Verfahren zum Herstellen eines Wellenleiters (10) nach Anspruch 1 oder einem der Ansprüche 3 bis 8 soweit auf Anspruch 1 rückbezogen, **dadurch gekennzeichnet, dass** eine Frontfläche (12) des Wellenleiters durch Plasmapolymerisation unter Verwendung von OFCB als Präkursor mit einer organische Fluorverbindungen aufweisenden Beschichtung beschichtet wird, und die Frontfläche (12) nach der Beschichtung plasmabehandelt wird, wodurch auf der Frontfläche (12) in Abhängigkeit von den eingestellten Verfahrensparametern ein Atzgras entsteht.

10. Verfahren zum Herstellen eines Wellenleiters (10) nach Anspruch 2 oder einem der Ansprüche 3 bis 8 soweit auf Anspruch 2 rückbezogen, **dadurch gekennzeichnet, dass** eine Frontfläche (12) des Wellenleiters durch Plasmapolvmerisation unter Verwendung von OFCB als Präkursor mit einer organische Fluorverbindungen aufweisenden Beschichtung beschichtet wird, und die Frontfläche (12) vor der Beschichtung plasmabehandelt wird. wodurch auf der Frontfläche (12) in Abhängigkeit von den eingestellten Verfahrensparametern ein Ätzgras entsteht, wobei die Dicke der PP-OFCB-Beschichtung (20) so gewählt wird, dass die zuvor in die Faserfrontfläche (12) eingebrachte Strukturierung (14) auch nach dem Beschichten an der äußeren Beschichtungsfläche noch vorhanden ist.

11. Verfahren nach Anspruch 89 oder 10, **dadurch gekennzeichnet, dass** bei der Plasmapolymerisation gleichzeitig oder alternierend OFCB und Benzol als Präkursoren verwendet werden, so dass die Frontfläche (12) gleichzeitig oder alternierend mit PP-OFCB und PP-Benzol beschichtet wird.

## Claims

1. Optical waveguide (10), and in particular an optical fibre, having a front face (12) which has a coating (20), the coating (20) comprising one or more organic fluorine compounds, **characterised in that** the coating is treated with plasma, whereby, as a function of the process parameters which are set, there is formed on the front face (12) etching-generated grass, the coating (20) comprising plasma polymerised octafluorocyclobutane (PP-OFCB).

2. Optical waveguide (10), and in particular an optical fibre, having a front face (12) which has a coating (20), the coating (20) comprising one or more organic fluorine compounds, **characterised in that** the front face (12) is treated with plasma, whereby, as a function of the process parameters which are set, there is formed on the front face (12) etching-generated grass, the coating (20) comprising plasma polymerised octafluorocyclobutane (PP-OFCB), the thickness of the PP-OFCB coating (20) being selected in such a way that the structuring (14) previously incorporated in the fibre front face (12) is still present on the outer surface of the coating even after the coating operation.

3. Waveguide according to claim 1 or 2, **characterised in that** the coating also comprises benzene and/or products of the polymerisation of benzene and in particular plasma polymerised benzene (PP-benzene).

4. Waveguide according to claim 3, **characterised in that** the coating comprises a layer of PP-OFCB and PP-benzene mixed in a preset ratio.

5. Waveguide according to claim 4, **characterised in that** the mixing ratio is set in such a way that the refractive index of the layer is matched to the refractive index of a material of the waveguide, the refractive index of the layer preferably being approximately n = 1.45.

6. Waveguide according to one of the preceding claims, **characterised in that** the coating comprises alternating layers of PP-OFCB and PP-benzene.

7. Waveguide according to one of the preceding claims, **characterised in that** the front face (12) of the waveguide (10) and/or the outer face of the coating (20) is treated with oxygen plasma to form the etching-generated grass.

8. Waveguide according to one of the preceding claims, **characterised in that** the front face (12) is a fibre facet.

9. Method of producing a waveguide (10) according to claim 1 or one of claims 3 to 8 where referred back to claim 1, **characterised in that** a front face (12) of the waveguide is coated with a coating comprising organic fluorine compounds by plasma polymerisation, using OFCB as a precursor, and the front face (12) is treated with plasma after the coating, whereby, as a function of the process parameters which are set, etching-generated grass arises on the front face (12).

10. Method of producing a waveguide (10) according to claim 2 or one of claims 3 to 8 where referred back to claim 2, **characterised in that** a front face (12) of the waveguide is coated with a coating comprising organic fluorine compounds by plasma polymerisation, using OFCB as a precursor, and the front face (12) is treated with plasma before the coating, whereby, as a function of the process parameters which are set, etching-generated grass arises on the front face (12), the thickness of the PP-OFCB coating (20) being selected in such a way that the structuring (14) previously incorporated in the fibre front face (12) is still present on the outer surface of the coating even after the coating operation.

11. Method according to claim 9 or 10, **characterised in that**, in the plasma polymerisation, OFCB and benzene are used simultaneously or alternately as precursors, the front face (12) thus being coated with PP-OFCB and PP-benzene simultaneously or alternately.

## Revendications

1. Guide d'ondes optique (10), en particulier fibre optique, comportant une surface frontale (12) présentant un revêtement (20), le revêtement (20) présentant un ou plusieurs composés fluorés organiques,
**caractérisé en ce que**
le revêtement est traité au plasma, moyennant quoi un "RIE-grass" (analogue à un herbage obtenu par attaque aux ions réactifs) est formé sur la surface frontale (12) en fonction des paramètres réglés du procédé, le revêtement (20) présentant de l'octafluorocyclobutane polymérisé au plasma (PP-OFCB).

2. Guide d'ondes optique (10), en particulier fibre optique, comportant une surface frontale (12) présentant un revêtement (20), le revêtement (20) présentant un ou plusieurs composés fluorés organiques,
**caractérisé en ce que**
la surface frontale (12) est traitée au plasma, moyennant quoi un "RIE-grass" est formé sur la surface frontale (12) en fonction des paramètres réglés du procédé, le revêtement (20) présentant de l'octafluorocyclobutane polymérisé au plasma (PP-OFCB), l'épaisseur du revêtement PP-OFCB (20) étant choisie de telle sorte que la structuration (14) introduite auparavant dans la surface frontale fibreuse (12) existe encore même après le revêtement sur la surface de revêtement extérieure.

3. Guide d'ondes selon la revendication 1 ou 2,
**caractérisé en ce que**
le revêtement présente en outre du benzol et/ou des produits de polymérisation de benzol, en particulier du benzol polymérisé au plasma (PP-benzol).

4. Guide d'ondes selon la revendication 3,
**caractérisé en ce que**
le revêtement présente une couche de PP-OFCB et de PP-benzol dans un rapport de mélange donné.

5. Guide d'ondes selon la revendication 4,
**caractérisé en ce que**
le rapport de mélange est réglé de telle sorte que l'indice de réfraction de la couche est adapté à l'indice de réfraction d'un matériau du guide d'ondes, l'indice de réfraction de la couche étant de préférence d'environ n = 1,45.

6. Guide d'ondes selon l'une des revendications précédentes,
**caractérisé en ce que**
le revêtement présente en alternance des couches de PP-OFCB et de PP-benzol.

7. Guide d'ondes selon l'une des revendications précédentes,
**caractérisé en ce que**
la surface frontale (12) du guide d'ondes (10) et/ou la surface extérieure du revêtement (20) est traitée au plasma oxygéné pour former le "RIE-grass".

8. Guide d'ondes selon l'une des revendications précédentes,
**caractérisé en ce que**
la surface frontale (12) est une facette de fibre.

9. Procédé de réalisation d'un guide d'ondes (10) selon la revendication 1 ou selon l'une des revendications 3 à 8 en combinaison avec la revendication 1,
**caractérisé en ce que**
une surface frontale (12) du guide d'ondes est revêtue par polymérisation au plasma en utilisant de l'OFCB à titre de précurseur pourvu de composés fluorés organiques, et la surface frontale (12) est traitée au plasma après le revêtement, moyennant quoi un "RIE-grass" se forme sur la surface frontale (12) en fonction des paramètres réglés du procédé.

10. Procédé de réalisation d'un guide d'ondes (10) selon la revendication 2 ou selon l'une des revendications 3 à 8 en combinaison avec la revendication 2,
**caractérisé en ce que**
une surface frontale (12) du guide d'ondes est revêtue par polymérisation au plasma en utilisant du OFCB à titre de précurseur pourvu d'un revêtement présentant des composés fluorés organiques, et la surface frontale (12) est traitée au plasma avant le revêtement, moyennant quoi un "RIE-grass" se forme sur la surface frontale (12) en fonction des paramètres réglés du procédé, l'épaisseur du revêtement PP-OFCB (20) étant choisie de telle sorte que la structuration (14) introduite auparavant dans la surface frontale fibreuse (12) existe encore même après le revêtement sur la surface de revêtement extérieure.

11. Procédé selon la revendication 9 ou 10,
**caractérisé en ce que**
lors de la polymérisation au plasma, on utilise simultanément ou en alternance du OFCB et du benzol à titre de précurseurs, de sorte que la surface frontale (12) est revêtue simultanément ou en alternance de PP-OFCB et de PP-benzol.
